# EUROPEAN PATENT APPLICATION

(11) **EP 2 112 689 A2**
(43) Date of publication of application: **28.10.2009**
(21) Application number: 09158252.8
(22) Date of filing: 20.04.2009
(51) Int. Cl.: H01L 23/427, H01L 23/367

(54) **Heat exchange device**

(30) Priority: 24.04.2008 EP 08155086
(71) Applicant: ABB Research Ltd., 8050 Zürich (CH)
(72) Inventor: Agostini, Bruno, CH-8953, Dietikon (CH); Yesin, Berk, CH-8038, Zürich (CH)
(74) Representative: ABB Patent Attorneys

(57) **Abstract**

A heat exchange device comprises a base 10 and a plurality of fins 20, 30. The plurality of fins 20, 30 arc in thermal contact with the base 10 to allow heat transport from the base to the fins. Further, the fins comprise at least one respective channel 21, 31 containing a working fluid. The fins 20, 30 are arranged in at least a first and a second row. The rows are preferably laterally displaced with respect to each other. Further, the first row and second row may be staggered with respect to each other.

## Description

### FIELD OF INVENTION

Embodiments of the present invention relate to a heat exchange device, e.g. a heat sink, in particular to a heat exchange device having fins and to a power module comprising such a heat exchange device. Embodiments of the present invention also relate to a method of manufacturing a heat exchange device.

### BACKGROUND OF THE INVENTION

Advances in integrated circuit technology have resulted in integrated circuit devices having increased circuit density, increased clocking frequencies, and increased power consumption per volume. As a result, advanced integrated circuit devices such as microprocessors generate substantial amounts of heat. To maintain the performance and prevent degradation due to heat, an integrated circuit is typically coupled to a heat sink to transfer and dissipate heat away from the integrated circuit device. A known heat sink is made of plain metal and has a base and fins. A heat exchange device can be active (externally powered, e.g. by a fan) or passive (not externally powered and typically involving convective air flow).

In order to dissipate the increasing amounts of heat efficiently from components such as electric devices, one might think that it is sufficient to simply increase the heat sink size, e.g. by increasing the fin height. However, doing so the fin efficiency decreases, mainly because of the limited thermal conductivity of the fins. As a consequence, the performance increase will not be proportional to the size increase but instead saturates at some point.

U.S. Pat. No. 7,150,312 B2 describes a cooling system having a stacked array of low profile heat pipes each with a plurality of micro tubes extended therethrough. The stacked low profile heat pipes are placed into thermal connection with heat producing components. A heat transfer fluid is contained in the micro tubes of the low profile heat pipes and removes the heat from the heat producing components.

However, the above systems still leave room for improvements in particular regarding their heat transport efficiency, their manufacturing cost, and their weight.

### SUMMARY OF THE INVENTION

In view of the above, the object is solved by a heat exchange device according to claim 1, a power unit comprising at least one of such heat exchange device and a method for producing such a heat exchange device, in accordance with the independent claims.

The term power module is understood hereinafter as an assembly comprising at least one power electronic and/or power electric device, that is thermally connected to the at least one heat exchange device according to the present invention. Please note that the terms power electronic and/or power electric device and heat emitting device as well as the term component are understood in an interchangeable manner hereinafter.

In one aspect of the invention, the heat exchange device comprises a base that is thermally connectable with at least one heat emitting device, i.e. at least one power component, for receiving heat and to allow a heat transport from the base (10) to an outer surface of the fins. The heat exchange device comprises also a plurality of fins. The plurality of fins is in thermal contact, i.e. thermally connected, e.g. by bonding, with the base to allow heat transport from the base to the fins, i.e. the outer surface of the fins. Further, at least one fin is a multi-port tube comprising a plurality of channels that is fluidly communicating with a working fluid. The term outer surface of a fin is understood to comprise a shell surface running in the circumferential direction of the fin in a direction indicated by the shape and type of the at least one channel. Moreover, the outer surface comprises and end surface of each fin, wherein said end surface is located at a distal end of the fin with respect to the base plate. The fins are arranged in at least one first and at least one second row to a matrix extending in a first direction and in a second direction. Hereinafter, each row is considered to comprise at least two fins. At least one of the first row and the second row extends in the first direction.

In an embodiment, the first row and the second row are laterally displaced with respect to each other. In other words, the at least one first row and the at least one second row are staggered with respect to each other in the first direction. Here, the term staggered means that a projected center of at least one fin of one of the rows is positioned, when seen in a cross section extending in the first and the second direction, in the first direction, inbetween the centers of two neighbouring fins of two adjacent rows when one row is geometrically projected in a lateral direction on the other row. The centers are understood as centers of area with respect to the cross section of their dedicated fins. The heat exchange device may comprise extra fins in addition to those described above. Said extra fins may not belong to any of the rows referred to above.

The advantages referred to above with respect to the heat exchange device do in general apply analogously for the power module and a method of manufacturing a heat exchange device disclosed below. Likewise the advantages referred to in regard of the method of manufacturing a heat exchange device apply for the heat exchange device and the power module, too.

In another aspect of the invention, the object is solved by a method of manufacturing a heat exchange device comprising the following activities/steps:
a) providing a base and a plurality of fins, wherein at least one of said fins comprises a multi-port tube with a plurality of channels;
b) thermally coupling the plurality of fins to the base such that a matrix is formed, wherein said matrix comprises at least a first row and at least one second row;
c) introducing a working fluid into at least one of the plurality of fins and the base; and
d) preventing the working fluid from escaping off the heat exchange device, i.e. the at least one of the plurality of fins and the base.

Depending on the embodiment, the base is thermally and mechanically coupled to the plurality of fins. Again, the plurality of fins comprises respective tubes, the tubes containing a working fluid. In an embodiment of the method the fins in at least one first and at least one second row are arranged such to one another that the rows are staggered and/or indented with respect to each other. The escapement of the working fluid is prevented by a suitable closing means, for example a plug, or by permanent sealing of a suitable filling opening provided for the step of introducing the working liquid ino the heat exchange body in at least one of a fin and or the base, e.g. by welding, glueing, brazing and the like.

In yet another aspect of the present invention, the object is solved by a power module comprising at least one heat emitting device such as a power electronic and/or electric device that is thermally connected to at least one heat exchange device according to the present invention.

### BRIEF DESCRIPTION OF THE DRAWINGS

A more complete understanding of the method and apparatus of the present invention may be obtained by reference to the following description when taken in conjunction with the accompanying drawings wherein:
- FIG. 1: is a perspective view of a heat exchange device according to a first embodiment of the invention;
- FIG. 2: is a perspective view of a heat exchange device according to a second embodiment of the invention, wherein the fins are horizontally cut;
- FIGS. 3a to 3c: are horizontal cross sectional views of different fins including their channels; and
- FIG. 4: is an excerpt of a top view of the staggered fins of heat exchange device of Fig. 1.

### DETAILED DESCRIPTION

In the following description of embodiments of the invention in reference to the Figures, like numerals are used for corresponding parts. The present invention is illustrated herein by example, and various modifications may be made.

### Overview

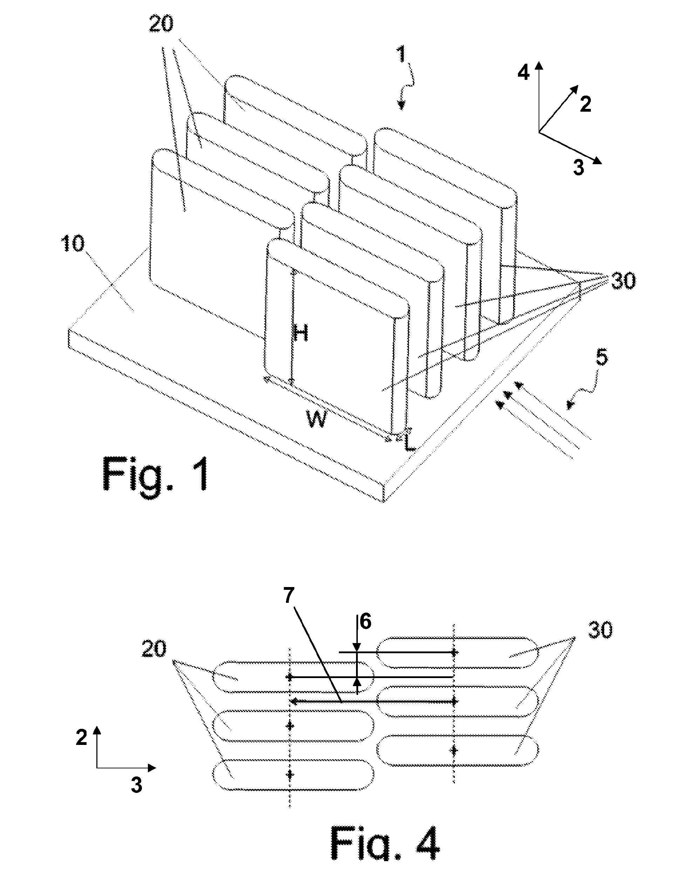

Fig. 1 shows a heat exchange device 1 being a first embodiment of the invention in a perspective view. The heat exchange device 1 is a heat sink for removing heat from at leat one heat generating component, formed by at least one heat emitting power electronic and/or electric device (not shown). The heat exchange device 1 of Fig. 1 includes a base 10 and fins 20, 30 arranged on a top side of the base 10 and in thermal contact with the base 10. Further, the flow 5 of the ambient cooling medium (generally air) is shown. The flow 5 is preferably generated by a fan or some other active flow generating means.

The base 10 is adapted for being coupled thermally with its bottom side to the heat generating component (not shown). During operation of the heat exchange device, heat generated/emitted by the heat generating component flows to the base 10, and from there to the fins 20, 30, which in turn dissipate the heat via their outer surfaces to an ambient medium (typically air) of sufficiently low temperature. The heat exchange device 1 may be passive or active. In the latter case the heat dissipation to the ambient medium is improved by a powered device such as a fan or a pump generating a flow of the ambient medium in the region of the fins 20, 30 for contributing to additional thermal capacity.

The heat generating component may be bolted, welded, clamped, glued or connected in any other suitable manner to the base 10 to achieve an effective thermal connection to the base 10. Further the base 10 can even be integrally formed with the heat generating component. In Fig. 1, the base 10 is shaped as a cuboid. In alternative embodiments, the base might also be shaped differently, e.g. in a curved or bent shape and / or with other geometries depending e.g. on spatial requirements.

The base 10 may be made of metal, e.g. Aluminum, and may be solid. Alternatively, the base 10 may have hollow body portions with a working fluid inside (similar to the fins 20, 30, see below) when in operation. In any case, is preferred that the base has a thermal conductivity of at least 200 W/(m K). In an embodiment, the base 10 has at least one hollow body portion with a working fluid inside and there is at least one opening in the base 10 on the side, on which the fins are arranged, by which opening the hollow body portion is fluidly connected to the channels and the fluid can flow from the base plate 10 to at least one channel 21, 31 of the fins 20, 30. Of course, there may also be a plurality of openings in the base plate 10 for the fluid to pass to a plurality or all of the channels 21, 31. In any case, the hollow body portions and the channels, which are connected to the hollow body portions, form a sealed volume for the fluid. In other words, the channels of at least two fins of the first row and/or the second row are fluidly connected to one another via the hollow body portion or portions of the base 10.

In an embodiment of the hollow body portion, the latter is designed such that it forms a fluid reservoir of working fluid for preventing the channels from running dry, e.g. if the heat exchange device is arranged in non-perpendicular manner to the ground, as well as for balancing the working fluid such that the channels of each fin get enough working fluid even in case a thermal distribution over the base is asymmetric.

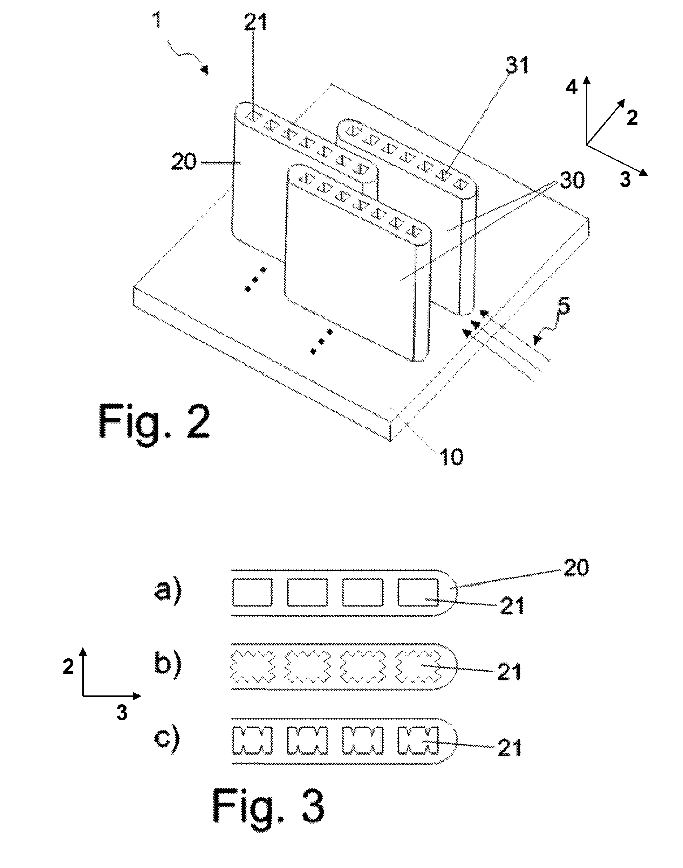

Likewise, the fins can be made from any material. Generally, the above-mentioned materials for the base 10 can also be used for the fins 20, 30 (more precisely for the portion of the fins outside the channels 21, 31 in Fig. 2) and, in particular, can be made of the same material as the base 10.

In order to transfer the heat efficiently to the ambient medium, the fins 20, 30 should have a large outer surface, hence a large fin size is desired. This means that the heat needs to be transported over a long distance. In conventional heat sinks with solid fins, however, increasing the fin size eventually brings no significant performance improvement due to the limited thermal conductivity of the fin material. This problem is at least partially overcome by the fins 20, 30, as will become evident from the following description of their internal structure.

### Heat pipe operation of the fins

At least one fin 20, 30 comprises a multi-tupe port with a plurality of channels extending therein. While the channels are not visible in Fig. 1, they can be seen in Fig. 2, showing a similar embodiment to that of Fig. 1, in which the fins 20, 30 are horizontally cut for the purpose of illustration such that the channels 21, 31 can be seen.

The channels 21, 31 contain a working fluid (not shown) when the heat exchange device is in operation. Due to the working fluid, the channels 21, 31 act as heat pipes. Heat pipes allow heat to be transferred efficiently even over relatively long distances according to the following heat pipe cycle:
1) On a higher temperature side of the channel (i.e. near base 10), the working fluid being a liquid evaporates to vapour, thereby absorbing thermal energy.
2) The vapour migrates along the channel to a lower temperature end of the channel (i.e. to the far end of the fins 20, 30 opposite the base 10).
3) The vapour condenses back to liquid, thereby releasing thermal energy.
4) The working fluid being liquid flows back to higher temperature end, at which the cycle may resume at step 1.

For the above heat-pipe cycle to take place, any liquid may be used as the working fluid. Preferably, a working fluid is chosen based on the following criteria:
- compatibility with the material of the channel walls (e.g. water is not compatible with aluminum channel walls, but is compatible with copper channel walls);
- sufficient latent heat at vaporization (which determines the maximum heat load that the heat pipe can handle); and
- an appropriate working pressure range (see above), in particular a working pressure below the maximum pressure that the fins can handle, e.g. below 2 bar, 10 bar or 100 bar depending on the fin material and on details of the fin construction.

Suitable working fluids are e.g. water, glycol, alcohol, other known refrigerants, or mixtures thereof. Also, any other liquid which is compatible with the channel wall material can be used.

Due to the heat pipe operation, the channels 21, 31 have an improved conduction efficiency. Hence, large amount of heat may be carried over a relatively long distance (also referred to a the fin height), even in the absence of a significant temperature gradient. In some situations, the fin efficiency (heat transport by the fins for some given temperature gradient) may even be more than doubled in comparison to conventional heat sinks with solid fins of same dimensions.

Thus, the above mechanism allows for relatively long fins, especially in the height direction running about perpendicularly to the contact surface of the base 10. In the following, the fin dimensions are denoted as first dimension L, a second dimension W and a third dimension H, as indicated in Fig. 1. The figures reveal that the fins are aligned with their longest extension with respect to their cross section in the second direction 3, whereas the rows of fins 20, 30 are running in a first direction 2 that is arranged about perpendicularly to the second direction 3 in the horizontal.

Hence, it is possible to provide fins with large height H, for example with a ratio H:W being at least 1:1, and preferably at least 2:1 or even at least 5:1. Further, the fins may have a ratio H:L of at least 10:1 or even at least 50:1. Further, the ratio W:L may be chosen to be at least 2:1 and preferably at least 10:1. In an embodiment, the absolute dimensions of a respective fin are W=20-40 mm, L= about 2 mm, and H=100-200 mm.

More formally, the directions are defined as follows: The second direction 3 is defined by the respective row as the direction in which the row extends; the first direction 2 is defined by the respective row as the direction orthogonal to the second direction 3 in a plane defined by the rows or by the base 10 surface; and the third direction 4 is the direction orthogonal to the first and second direction 3 or, put more simply, orthogonal to the surface of the base 10 in a common virtual plane. The directions according to these definition may change from fin to fin e.g. in the case of a curved row.

As a further advantage of the channels resides in that a great portion of the metal inside the fins in a conventional full-metal fin is replaced by the working fluid in the heat exchange device according to the present invention, such that the fins according to the present invention are substantially lighter than the conventional ones.

### Fins being multi-tube ports

For the above heat-pipe operation, it is in principle sufficient that the fins 20, 30 comprise at least two channels per fin. In a preferred embodiment, however, the fins are formed as multi-port tubes having a plurality of parallel elongated channels 21, 31 (preferably in the height, i.e. third dimension H extending in the third direction 4). In Fig. 2, the fins 20, 30 are horizontally cut in order to expose the channels 21,31.

Depending on the embodiment, the multi-port tubes with the parallel channels are aluminum multi-port tubes. They are typically produced using a simple aluminum extrusion process and are hence available at relatively low cost. This is a significant advantage over other more conventional heat pipe systems, where tailored cooling fins/heat pipes where subject to factors like the manufacturability, cooling particularities and limited thermal capacity in terms of height of the fins. Using standard multi-tube port profiles contributes essentially to lower overall costs in that the third dimension H of the fins allows for more flexibility of the ever varying factors mentioned above.

In Fig. 2, the channels 21, 31 shown have an elongated, strip-like, quasi square cross section. Instead of the quasi square or rectangular cross section, any suitable other cross section may be used, as long as the function remains essentially untouched. Some examples of further cross sections of the channels 21 are shown in Figs. 3a to 3c. Fig. 3a shows again the square cross section of Fig. 2. Alternatively, as shown in Figs. 3b and 3c, the inner surface of the channels 21 may comprise fin-like protrusions and / or groove-like recesses. The channels 31 of the fins 30 may be formed likewise. Depending on the embodiment of the heat exchange device, the latter may comprise one single kind of fins in terms of shape, size and cross section whereas other embodiments feature at least to kind of fins having different cross-sections.

More generally the cross section of the channels 21, 31 may be either convex (as in Fig. 3a) or concave (as in Fig. 3b, 3c). The inner channel surface may be substantially smooth (as in Fig. 3a) or not (as in Fig. 3b, 3c), "substantially" meaning that edges are disregarded if they define the overall shape of the cross section, such as the corners of the square of Fig. 2.

Smooth inner surfaces and / or convex cross sections as in Fig. 3a are suitable e.g. if there is a gravity gradient along the channels (e.g. if the fins are aligned vertically), because then step 4 of the heat pipe cycle (see above) is assisted by gravity acting on the liquid. On the other hand, non-smooth inner surfaces and / or concave cross sections and in particular grooved or finned channels as in Figs. 3b, 3c, are preferred especially for horizontally aligned fins, because then step 4 may be assisted by capillary pumping provided by the concave structures (e.g. fin-like protrusions and / or groove-like recesses) due to surface tension of the working fluid. As an alternative to the fin-like protrusions or groove-like recesses, other capillary pumping means may be provided in the channels 21, 31, for example a rod inside the channel (such a channel would also be described as concave). Depending on the particularities of the fins 20, 30, the at least two channels of one fin comprises different sizes, shapes and/or cross-sections of the channels.

The fins 20 and 30 and their channels 21, 31 can be of any shape, in particular any shape manufacturable by extrusion. While in Figs. 1 and 2 substantially cuboidic fins are shown, fins of any shape (e.g. cylindrical fins etc) may be used depending on expected air flow and on other geometric constraints. Fin shapes having at least one pair of substantially flat opposite sides in the first direction 2 are somewhat preferred. In Fig. 2, the channels are shown to be arranged in a linear and/or straight row, but any other arrangement of one or more channels within the fins is also possible.

### Arrangement of the fins on the base

In Figs. 1 and 2, the fins are arranged in two different rows, namely in a first row of fins 20 and a second row of fins 30. The rows are laterally displaced with respect to each other. For example, the fins may be arranged in an m x n matrix with m and n ≥ 2 (m being a row and n a column of the matrix). In other embodiments, the first row may be distinguished from the second row in some other manner in addition to or instead of a lateral displacement. Such a distinction may be e.g. based on the size or the shape of the fins.

The arrangement in a plurality of rows has the following effects: Due to the fins being divided into several rows, the flow of the ambient medium is also subdivided into several zones. The presence of these zones generally may increase the heat transfer from the fins to the ambient medium. This effect is particularly pronounced for a staggered arrangement, as described below. As a further advantage, due to the arrangement in several rows one standard size of fins 20, 30 may be used for different sizes and shapes of the base 10, thus decreasing the number of different components to be stocked, i.e. heat exchange devices having differing key data.

The embodiment as shown in Figs. 1 and 2 reveals that the first row and second row are staggered with respect to each other. The meaning of the term staggered is best understood with reference to Fig. 4, which is an excerpt of a top view of the fins 20, 30 of the heat exchange device of Fig. 1. The respective rows of fins 20 and 30 are indicated by dashed lines. Further, the centers of the fins are indicated by solid crosses. Further, a lateral projection of the center of the middle fin 30 onto the other row (row of fins 20) is represented by a thick horizontal arrow, whereas the arrow head indicates the projected position of the center onto the other row. As can be seen in Fig. 4, the projected center, i.e. the arrow head, is positioned, in a longitudinal direction, in between the centers of two neighbouring fins of the other row. This illustrates the more general definition of the term staggered, meaning that if the fins of a selected row are projected in a lateral direction onto another row, a projected center of at least one fin of the selected row (in Fig. 4: the projected center of the middle one of fins 30, indicated by the arrow head) is positioned, in the second direction 3, inbetween the centers of two neighbouring fins of the other row. In Fig. 4, the projection arrow is orthogonal to both rows (the rows being parallel and running in the first direction 2). Also for curved and / or non-parallel rows, the projection is defined such that the projection arrow is orthogonal to the row section onto which the center is to be projected.

The fins of the first and second row of another embodiment are staggered in the first direction 2 and alternating in an indenting manner in the second direction 3 such as shown in Figs 1, 2 and 4. Depending on the embodiment, the first and second row are longitudinally offset from one another by a predetermined offset. As shown in Fig. 4, the offset may be about 0,5, i.e. half of the spacing in the first direction 2 between two neighbouring fin centers of one row. In other words, the first row is displaced from the second row in the second direction 3 by a predetermined first offset 6, in particular a first offset 6 being at least as long as a fin 20, 30 in its longest extension, and/or in the first direction 2 by a predetermined second offset 7 of about half the distance between two neighbouring fins 20 of the first row.

The lateral spacing between the rows may be varied as well. In Fig. 1, the first row is substantially laterally displaced from the second row about the first offset 6. In Fig. 2, the first row and the second row have a lateral overlap such that the first and the second row of fins are arranged to one another in a staggered manner in the second direction 3.

If the rows are staggered, the heat transfer increases due to boundary layer developement. This is because for typical Reynolds number between the fins (e.g. 3000), the flow is slightly turbulent but close to laminar (the transition between laminar and turbulent being normally in a range of Reynolds numbers from about 2300 to about 10000). As a consequence the length required for the boundary layer to develop is typically longer than heat sink length in the flow direction of the ambient medium. Typical numbers are a length of about 1000 mm for the boundary layer to develop completely, and a heat sink length of 200 mm in the flow direction, that is the second direction 3.

According to model calculations, for a single row of fins of 200 mm length the heat transfer coefficient would decrease by a factor 3.3 in the flow direction (compared to a fully developed boundary layer). If instead 5 staggered rows of 40 mm fins are used, by means of example, over the 200 mm length, the decrease is be a 1.2 ratio only, hence a much better heat transfer performance than the case of the single row. For the staggered arrangement, a larger pressure drop is required. This requirement can be partially compensated by using a shorter heat sink due to the increased efficiency of the staggered fins.

### Manufacturing of the heat sink

The fins 20, 30 can be manufactured by an extrusion process. Subsequently, the channels are filled with the working fluid by any methods known for filling heat pipes. According to one example method, the channels are first evacuated, then the working fluid is filled into the channels, and then the ends of the channels are sealed by any suitable method, e.g. by any method known for the sealing of heat pipes such that the working liquid is prevented from escaping off the heat exchange device. Then, the fins are connected to the base. To this purpose, any assembly method for stacking fins to a base in conventional heat sinks may be used.

Alternatively, the fins may be provided with an upper portion having the channels and a lower portion being solid, i.e. not having a channel. Such fins may be produced as described above, whereby additionally the lower part of the fins is mechanically squeezed such as to make the channel disappear in that part, and whereby optionally material is added to the lower portion (either into the channels before squeezing or to the outside) in order to compensate or overcompensate for any loss in cross-sectional area due to the squeezing. Then, the lower portions of the fins can be connected to each other in any suitable manner, whereby the base is formed from these lower portions.

By these methods, fins are created whose channels are closed on both ends and hence do not communicate with each other. In particular, the channels belonging to different fins are fluidly non-communicating with one another. In other words, the channels 21, 31 of at the at least one first row and the channels 21, 31 of the at least one second row are fluidly disconnected of one another.

In the foregoing specification, the invention has been described with reference to specific exemplary embodiments thereof. It will, however, be evident that various modifications and changes may be made thereto without departing from the broader spirit and scope of the invention as set forth in the appended claims. For example, the heat exchange device may comprise still more fins than those described above (e.g. individual fins or a third, fourth, row of fins, etc.). The specification and drawings are, accordingly, to be regarded only as illustrations.

## Claims

1. A heat exchange device (1) comprising
- a base (10) that is thermally connectable with at least one heat emitting device for receiving heat, and
- a plurality of fins (20, 30), which are in thermal contact with the base (10) to allow heat transport from the base (10) to an outer surface of the fins (20, 30), wherein at least one fin (20, 30) is a multi-port tube comprising a plurality of channels (21, 31), and wherein the fins (20, 30) are arranged in at least one first row and at least one second row to a matrix extending in a first direction (2) and in a second direction (3), wherein at least one of the first row and the second row extends in the first direction (2).

2. The heat exchange device according to claim 1, wherein the first row and second row are staggered with respect to each other in the first direction (2).

3. The heat exchange device according to claim 2, wherein the at least one first row and the at least one second row of the matrix are indented to one another in the second direction (3).

4. The heat exchange device according to claim 2 or 3, wherein the first row is displaced from the second row in the second direction (3) by a predetermined first offset (6), in particular a first offset (6) being at least as long as a fin (20, 30) in its longest extension, and/or in the first direction (2) by a predetermined second offset (7) of about half the distance between two neighbouring fins (20) of the first row.

5. The heat exchange device according to any one of claims 1 to 4, wherein at least one of the channels (21, 31) has a smooth inner surface and/or wherein at least one of the channels (21, 31) has an inner surface with at least one of a fin-like protrusion and a groove-like recess.

6. The heat exchange device according to any one of claims 1 to 5, wherein the channels (21, 31) of at least two fins of the first row and/or the second row are fluidly connected to one another via the base (10).

7. The heat exchange device according to any one of claims 1 to 6, wherein the channels (21, 31) of at the at least one first row and the channels (21, 31) of the at least one second row are fluidly disconnected of one another.

8. The heat exchange device according to any one of claims 1 to 7, wherein the fins (20, 30) have each a first dimension (L) extending in the first direction (2), and a second dimension (W) extending in the second direction (3), and wherein a ratio of the second dimension to the first dimension is at least 2:1, preferably at least 5:1.

9. The heat exchange device according to claim 8, wherein the fins (20, 30) are limited each in a direction defined by at least one of the channels (21, 31) by a third dimension (H), and wherein the ratio of the third dimension to the second dimension is at least 1:1, preferably at least 2:1.

10. The heat exchange device according to any one of claims 1 to 9, wherein the first row is laterally offset from the second row in the second direction (3).

11. The heat exchange device according to any one of claims 1 to 10, wherein the fins (20, 30) of the at least one of the first row and the second row are substantially aligned in a linear and/or a straight manner.

12. The heat exchange device according to claim 6, wherein the base (10) comprises at least one hollow body portion, that is fluidly connected by at least one opening on the side, on which the fins (20, 30) are arranged, said opening fluidly connecting the channels (21, 31) such that the working fluid can flow between channels (21, 31) of at least two fins (20, 30) via the at least one hollow body portion.

13. A method of manufacturing a heat exchange device (1), comprising the steps of:
a) providing a base (10) and a plurality of fins (20, 30), wherein at least one of said fins (20, 30) comprises a multi-port tube with a plurality of channels (21, 31);
b) thermally coupling the plurality of fins (20, 30) to the base (10) such that a matrix is formed, wherein said matrix comprises at least a first row and at least one second row,
c) introducing a working fluid into at least one of the plurality of fins (20, 30) and the base (10); and
d) preventing the working fluid from escaping off the at least one of the plurality of fins (20, 30) and the base (10).

14. The method of manufacturing a heat exchange device (1) as claimed in claim 13, wherein the heat exchange device (1) is a heat exchange device according to any one of claims 1 to 12.

15. Power module comprising at least one heat emitting device such power electronic and/or electric device that is thermally connected to at least one heat exchange device (1) according to any one of claims 1 to 12.
